# EUROPÄISCHE PATENTSCHRIFT

(11) **EP 1 673 817 B1**
(45) Veröffentlichungstag und Bekanntmachung des Hinweises auf die Patenterteilung: **02.01.2008**
(21) Anmeldenummer: 04791225.8
(22) Anmeldetag: 14.10.2004
(51) Int. Cl.: H01L 41/053

(54) **AUFNAHMEHÜLSE FÜR EINEN PIEZOAKTOR**
RECEPTION BUSH FOR A PIEZOELECTRIC ACTUATOR
MANCHON DE RECEPTION POUR UN ACTIONNEUR PIEZO-ELECTRIQUE

(30) Priorität: 14.10.2003 DE 10347768
(43) Veröffentlichungstag der Anmeldung: 28.06.2006
(73) Patentinhaber: Siemens VDO Automotive AG, 93055 Regensburg (DE)
(72) Erfinder: DÖLLGAST, Bernd, 91054 Erlangen (DE); GILG, Horst, 93142 Maxhütte (DE); HAUBOLD, Jörg, 09247 Kändler (DE); SANFTLEBEN, Emanuel, 93102 Pfatter (DE); SCHUH, Carsten, 85598 Baldham (DE); UNRUH, Marcus, 93197 Zeitlarn (DE); ZUMSTRULL, Claus, 93128 Regenstauf (DE)
(86) Internationale Anmeldenummer: PCT/EP2004/052540
(87) Internationale Veröffentlichungsnummer: WO 2005/038940

(56) Entgegenhaltungen:
- WO-A-20/04047191
- DE-A1- 19 715 487
- US-A- 5 004 945

## Beschreibung

Die Erfindung betrifft eine Aufnahmehülse für einen Piezoaktor, insbesondere für einen Piezoaktor zum Antrieb eines Injektors einer Einspritzanlage für eine Brennkraftmaschine, gemäß dem Oberbegriff des Anspruchs 1.

Aus DE 197 15 487 A1 ist ein piezoelektrischer Aktor mit einem Hohlprofil bekannt, bei dem Kontaktstifte, die über Kontaktfahnen mit dem piezoelektrischen Aktor verbunden sind, in einer genau definierten Lage in dem Hohlprofil angeordnet sind.

In modernen Einspritzanlagen für Brennkraftmaschinen werden zum Antrieb der Injektoren zunehmend Piezoaktoren eingesetzt. Bei der Montage derartiger Piezoaktoren wird herkömmlicherweise ein piezokeramischer Stapel in eine zylindrische Aufnahmehülse eingebaut, die aus zwei zylindrischen Hülsenteilen besteht.

In den Stirnflächen der beiden zylindrischen Hülsenteile sind hierbei Aussparungen angeordnet, durch die der piezokeramische Stapel nach außen ragt, wobei die Aufnahmehülse etwas kürzer als der piezokeramische Stapel ist, so dass der Kraftschluss nur über die Stirnflächen des piezokeramischen Stapels erfolgt.

Darüber hinaus sind in der Stirnfläche eines Hülsenteils zwei Durchführungen angeordnet, durch die zwei Anschlussstifte herausragen können, die der elektrischen Kontaktierung des Piezoaktors dienen.

Beim Zusammenbau dieser bekannten Aufnahmehülse wird der piezokramische Stapel zunächst so in eines der beiden Hülsenteile eingesetzt, dass die Aussparung in dem Hülsenteil den piezokeramischen Stapel aufnimmt. Anschließend wird dann das zweite Hülsenteil aufgesetzt und auf das andere Hülsenteil aufgedrückt, bis die beiden Hülsenteile durch eine Rastverbindung miteinander verbunden sind. Bei dieser Montage muss darauf geachtet werden, dass die beiden Hülsenteile eine vorgegebene Winkellage relativ zueinander einhalten, damit die Aussparungen in den Stirnflächen der beiden Hülsenteile in Deckung übereinander liegen, so dass diese den piezokeramischen Stapel aufnehmen. Die korrekte Winkellage der beiden Hülsenteile relativ zueinander ist auch wichtig, damit die Anschlussstifte für den piezokeramischen Stapel durch die Durchführungen hindurch nach außen ragen können. Anschließend wird die bekannte Aufnahmehülse dann mit einer vergussmasse (z. B. Silikon) gefüllt, wodurch der piezokeramische Stapel und die Anschlussstifte fixiert werden.

Nachteilig an der vorstehend beschriebenen bekannten Aufnahmehülse für einen Piezoaktor ist die Tatsache, dass es beim Zusammenbau zu einer Fehlausrichtung der Anschlussstifte für die elektrische Kontaktierung des Piezoaktors kommen kann.

Der Erfindung liegt deshalb die Aufgabe zugrunde, die vorstehend beschriebene bekannte Aufnahmehülse dahingehend zu verbessern, dass Fehlausrichtungen der Anschlussstifte für die elektrische Kontaktierung des Piezoaktors beim Zusammenbau verhindert werden.

Diese Aufgabe wird, ausgehend von der eingangs beschriebenen bekannten Aufnahmehülse gemäß dem Oberbegriff des Anspruchs 1, durch die kennzeichnenden Merkmale des Anspruchs 1 gelöst.

Die Erfindung beruht auf der technischen Erkenntnis, dass die Fehlausrichtung der elektrischen Anschlussstifte beim Zusammenbau der Aufnahmehülse dadurch verursacht wird, dass diese nur einseitig in den zugehörigen Durchführungen fixiert sind und deshalb verkanten können.

Die Erfindung umfasst deshalb die allgemeine technische Lehre, eine Führung vorzusehen, welche die Anschlussstifte für die elektrische Kontaktierung des Piezoaktors während des Zusammenbaus fixiert und dadurch eine Fehlausrichtung verhindert. Die Durchführungen für die Herausführung der Anschlussstifte aus der Aufnahmehülse sind hierbei vorzugsweise in dem einen Hülsenteil angeordnet, während die erfindungsgemäße vorgesehene zusätzliche Führung für die beiden Anschlussstifte vorzugsweise in dem anderen Hülsenteil angeordnet ist, so dass die Anschlussstifte beidseitig geführt werden, wodurch eine Fehlausrichtung verhindert wird.

Vorzugsweise sind die Führungen für die beiden Anschlussstifte an einem der beiden Hülsenteile einstückig angeformt, wobei sich die Führung vorzugsweise an der Mantelfläche und an der Stirnfläche der Hülse innen befindet.

In einem bevorzugten Ausführungsbeispiel der Erfindung sind die Führungen für jeden der beiden Anschlussstifte topfförmig ausgebildet, so dass die Enden der Anschlussstifte jeweils von einer topfförmigen Führung gehalten werden.

Vorzugsweise sind die Führungen für die Anschlussstifte des Piezoaktors jeweils als Querlager ausgebildet und verhindern eine Querbewegung der geführten Enden der Anschlussstifte. Da die Anschlussstifte vorzugsweise auch in den Durchführungen in der Stirnfläche des anderen Hülsenteils geführt werden, wird durch derartige Querlager eine Schwenkbewegung der Anschlussstifte unterbunden.

Darüber hinaus sind die Führungen für die Anschlussstifte des Piezoaktors vorzugsweise auch als Axiallager ausgebildet und verhindern eine Axialbewegung der Anschlussstifte zumindest in einer Axialrichtung bezüglich der Symmetrieachse der Aufnahmehülse. Eine derartige Axiallagerung der beiden Anschlussstifte ist vorteilhaft, um sicherzustellen, dass die beiden Anschlussstifte gleich weit aus der Aufnahmehülse herausragen.

Ferner sind die Führungen für die Anschlussstifte des Piezoaktors vorzugsweise auch als Kippmomentenlager ausgebildet und verhindern eine Kippbewegung der Anschlussstifte. Auf diese Weise wird die Montage der erfindungsgemäßen Aufnahmehülse wesentlich erleichtert, da die Anschlussstifte nach dem Einsetzen in die vorzugsweise topfförmig ausgebildeten Führungen des einen Hülsenteils bereits korrekt ausgerichtet sind, so dass das andere Hülsenteil einfach aufgesetzt werden kann, wobei die bereits zuvor korrekt ausgerichteten Anschlussstifte durch die zugehörigen Durchführungen in dem aufzusetzenden Hülsenteil hindurchstoßen.

Die Erfindung umfasst ferner die allgemeine technische Lehre, eine Verdrehsicherung vorzusehen, damit die beiden Hülsenteile der Aufnahmehülse relativ zueinander eine vorgegebene Winkellage einhalten, welche die Montage ermöglicht.

Eine derartige Verdrehsicherung bietet den Vorteil, dass bei der Montage der erfindungsgemäßen Aufnahmehülse nicht auf die exakte Winkelausrichtung der beiden Hülsenteile geachtet werden muss, da diese durch die Verdrehsicherung sichergestellt wird.

In einem bevorzugten Ausführungsbeispiel der Erfindung weist die Verdrehsicherung eine Nut-Feder-Verbindung auf, die aus einer an einem der beiden Hülsenteile angebrachten Nut und einer an dem anderen Hülsenteil angebrachten, formangepassten Feder besteht, die im montierten Zustand in die Nut eingreift. Die verdrehsicherung kann auch mehrere Nuten und Federn aufweisen, die über den Umfang der Hülsenteile verteilt angeordnet sind und jeweils paarweise ineinander eingreifen, um eine vorgegebene Winkellage zwischen den beiden Hülsenteilen einzuhalten.

Vorzugsweise weist die Nut und/oder die Feder einer derartigen Verdrehsicherung eine Einlaufschräge auf, welche die Montage der erfindungsgemäßen Aufnahmehülse erleichtert, indem die Einlaufschräge eine Vormontage der beiden Hülsenteile auch mit einem Winkelversatz ermöglicht, der dann bei der Montage durch die Einlaufschräge ausgeglichen wird. Der maximal zulässige Winkelversatz zwischen den beiden Hülsenteilen kann hierbei im Bereich zwischen 1° und 10° liegen, was die Montage der erfindungsgemäßen Aufnahmehülse wesentlich erleichtert, da die Anforderungen an die Winkelausrichtung der beiden Hülsenteile verringert werden.

Im montierten Zustand der erfindungsgemäßen Aufnahmehülse sind die einzelnen Hülsenteile vorzugsweise durch eine Steckverbindung miteinander verbunden, wobei die Steckverbindung eine konstruktionsbedingt vorgegebene Steckverbindungslänge aufweist. Als Steckverbindungslänge ist hierbei der Weg zu verstehen, um den die beiden Hülsenteile relativ zueinander bewegt werden müssen, um von einem völlig getrennten Zustand in den montierten Zustand überzugehen. Bei einer derartigen Steckverbindung ist es vorteilhaft, wenn sich die Einführschräge der Nut bzw. Feder in Axialrichtung der Hülsenteile nur über einen Teil der Steckverbindungslänge erstreckt, während der restliche Teil der Steckverbindungslänge von der Verdrehsicherung eingenommen werden kann. Würde sich die Einführschräge nämlich über die gesamte Steckverbindungslänge erstrecken, so würde die Verdrehsicherung nur dann wirken, wenn die beiden Hülsenteile vollständig zusammengesteckt sind. Falls sich die Einführschräge dagegen nur über einen Bruchteil der Steckverbindungslänge erstrecken würde, so müsste der zwischen den beiden Hülsenteilen bei der Vormontage zunächst auftretende winkelversatz auf einer sehr kurzen Aufstecklänge ausgeglichen werden, was mechanisch nachteilig ist. Bei der erfindungsgemäßen Aufnahmehülse erstreckt sich die Einlaufschräge deshalb vorzugsweise über 10% bis 50% der gesamten Steckverbindungslänge, was einen.guten Kompromiss zwischen einer sicheren Wirkung der Verdrehsicherung einerseits und einem guten Ausgleich des Winkelversatzes zwischen den zu montierenden Hülsenteilen darstellt.

Weiterhin ist zu erwähnen, dass sich die Nut und/oder die Feder der Verdrehsicherung vorzugsweise von dem jeweils freien Ende des jeweiligen Hülsenteils ausgehend mindestens über einen Teil der Steckverbindungslänge erstreckt, so dass die Feder bereits während des Zusammensteckens der beiden Hülsenteile und nicht erst im vollständig zusammengesteckten Zustand in die zugehörige Nut eingreift.

Darüber hinaus ist es vorteilhaft, wenn sich die Nut und/oder die Feder der Nut-Feder-Verbindung über die gesamte Steckverbindungslänge der Steckverbindung erstreckt, wobei die Einlaufschräge nur einen Teil der Steckverbindungslänge einnimmt, während die Verdrehsicherung den gesamten Rest der Steckverbindungslänge einnimmt. Die Nut-Feder-Verbindung wirkt hierbei also auf einem Teil der Steckverbindungslänge als Verdrehsicherung und auf dem anderen Teil der Steckverbindungslänge als Montagehilfe zum Ausgleich eines winkelversatzes zwischen den zu montierenden Hülsenteilen.

Besonders vorteilhaft ist es, wenn bei der Nut-Feder-Verbindung sowohl die Nut als auch die Feder eine Einlaufschräge aufweist, so dass die Einlaufschrägen von Nut und Feder paarweise aufeinander gleiten, so dass ein Winkelversatz zwischen den zu montierenden Hülsenteilen bei geringen mechanischen Belastungen ausgeglichen wird. Vorzugsweise weist die Einlaufschräge der Nut hierbei im Wesentlichen den gleichen Einlaufwinkel auf wie die Einlaufschräge der Feder, so dass die beiden Einlaufschrägen bei der Montage im Wesentlichen planparallel und damit verschleißarm aufeinander gleiten.

Die Verbindung der beiden Hülsenteile erfolgt im montierten Zustand vorzugsweise durch eine herkömmliche Rastverbindung, jedoch sind grundsätzlich auch andere form- und kraftschlüssige Verbindungen zwischen den zu montierenden Hülsenteilen möglich.

Bei einer Verwendung einer Rastverbindung ist es vorteilhaft, wenn die Einlaufschräge beim Zusammenstecken der beiden Hülsenteile nur bis zu dem Rastpunkt wirkt, wohingegen nach dem Überschreiten des Rastpunktes der Rastverbindung ausschließlich eine Verdrehsicherung besteht. Ein möglicher Winkelversatz zwischen den zu montierenden Hülsenteilen wird hierbei also ausgeglichen, bevor der Rastpunkt der Rastverbindung überschritten wird.

Hinsichtlich der Gestaltung der Einlaufschräge bestehen vielfältige Möglichkeiten, jedoch ist die Einlaufschräge bei dem bevorzugten Ausführungsbeispiel im Wesentlichen gerade und ungekrümmt. Es ist jedoch im Rahmen der Erfindung auch möglich, dass die Einlaufschräge beispielsweise einen gekrümmten, kurvenförmigen Verlauf aufweist.

Darüber hinaus ist zu erwähnen, dass die Einlaufschräge bei dem bevorzugten Ausführungsbeispiel übergangslos in die Verdrehsicherung übergeht. Beispielsweise kann die Einlaufschräge mit einem Knick in die Verdrehsicherung übergehen, jedoch ist es auch möglich, dass die Einlaufschräge knickfrei in die Verdrehsicherung übergeht.

Bei der Beschreibung des Standes der Technik wurde eingangs bereits erwähnt, dass die beiden Hülsenteile in ihren Stirnflächen jeweils Aussparungen zur Führung des Piezoaktors aufweisen, was vorzugsweise auch bei der erfindungsgemäßen Aufnahmehülse der Fall ist.

Im montierten Zustand ragt der Piezoaktor durch diese Aussparungen aus der erfindungsgemäßen Aufnahmehülse nach außen, wobei der Piezoaktor mit den Aussparungen vorzugsweise eine Passung bildet, deren Winkelspiel größer ist als das Winkelspiel der Verdrehsicherung, um zu verhindern, dass die erfindungsgemäße Aufnahmehülse Torsionskräfte auf den Piezoaktor ausübt.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

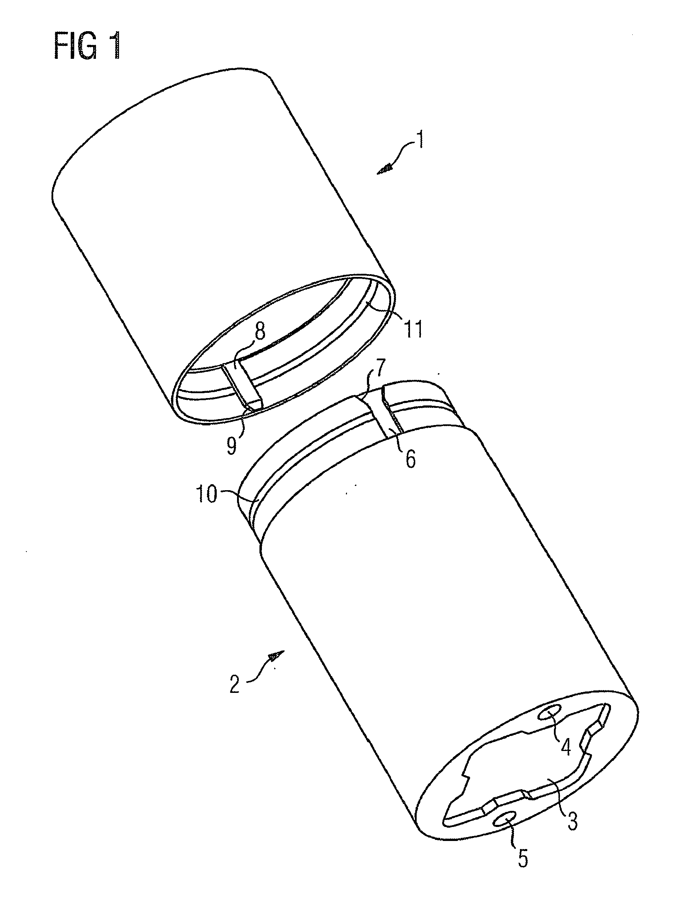

- Figur 1: eine Querschnittsansicht einer erfindungsgemäßen Aufnahmehülse für einen Piezoaktor zum Antrieb eines Injektors einer Einspritzanlage für eine Brennkraftmaschine sowie
- Figur 2: eine andere Querschnittsansicht der Aufnahmehülse aus Figur 1.

Die in den Zeichnungen dargestellte Aufnahmehülse besteht im wesentlichen aus zwei zylindrischen Hülsenteilen 1, 2, in deren Stirnflächen jeweils eine Aussparung 3 zur Führung des Piezoaktors angeordnet ist, wobei die in dem Hülsenteil 1 angeordnete Aussparung in der Zeichnung verdeckt ist.

Darüber hinaus sind in den Stirnflächen der beiden Hülsenteile 1, 2 jeweils zwei kreisförmige Bohrungen 4, 5 angeordnet, die in den jeweiligen Stirnflächen auf gegenüberliegenden Seiten angeordnet sind und eine Durchführung von Anschlusspins des Piezoaktors ermöglichen. Die in dem Hülsenteil 1 angeordneten Bohrungen sind hierbei ebenfalls verdeckt.

Bei der Montage der Aufnahmehülse wird zunächst der Piezo-Stack in das Hülsenteil 2 eingesetzt, bis der Piezo-Stack durch die Aussparung 3 nach außen hindurchragt, wobei die Aussparung 3 den Piezo-Stack mechanisch führt. Die Anschlusspins des Piezo-Stacks ragen dann durch die Bohrungen 4, 5 in dem Hülsenteil 2 nach außen, was eine elektrische Kontaktierung des Piezo-Stacks ermöglicht.

Anschließend wird dann das Hülsenteil 1 so auf das Hülsenteil 2 aufgesteckt, dass die Aussparung 3 in dem Hülsenteil 2 ungefähr in Deckung unter der entsprechenden Aussparung in der Stirnfläche des Hülsenteils 1 liegt.

Zur Erleichterung dieser Montage sind in der äußeren Mantelfläche des Hülsenteils 2 auf gegenüberliegenden Seiten zwei axial verlaufende Nuten 6 angeordnet, deren Nutbreite sich zu dem freien Ende des Hülsenteils 2 hin in Richtung auf das andere Hülsenteil 1 in Form einer Einlaufschräge 7 erweitert.

In der inneren Mantelfläche des anderen Hülsenteils 1 sind auf gegenüberliegenden Seiten zwei entsprechend formangepasste Federn 8 angeordnet, deren Breite sich zu dem freien Ende des Hülsenteils 1 hin in Richtung auf das andere Hülsenteil 2 in Form einer Einlaufschräge 9 verringert.

Beim Aufstecken des Hülsenteils 1 auf das Hülsenteil 2 ist also vorteilhafterweise keine exakte Winkelausrichtung der beiden Hülsenteile 1, 2 relativ zueinander erforderlich, da ein Winkelversatz durch die Einlaufschrägen 7, 9 ausgeglichen wird.

Die Einlaufschrägen 7 der Nuten 6 weisen hierbei den gleichen Einlaufwinkel auf wie die Einlaufschrägen 9 der Federn 8, so dass die Einlaufschrägen 7, 9 bei der Montage planparallel und damit verschleißarm aufeinander gleiten.

Im montierten Zustand sind die beiden Hülsenteile 1, 2 dann durch eine Rastverbindung miteinander verbunden, die aus einer umlaufenden Nut 10 in dem Hülsenteil 2 und einem entsprechenden umlaufenden Rastvorsprung 11 in der inneren Mantelfläche des Hülsenteils 1 besteht.

Weiterhin ist zu erwähnen, dass sich die Einlaufschrägen 7, 9 nur über einen Teil von ungefähr 30% der Steckverbindungslänge erstrecken, während die Nut-Feder-Verbindung zwischen der Nut 6 und der Feder 8 auf dem restlichen Teil der Steckverbindungslänge ausschließlich der Verdrehsicherung dient. Auf diese Weise wirkt die Verdrehsicherung bereits dann, wenn der Rastpunkt der Rastverbindung bei der Montage überschritten ist.

Weiterhin ist zu erwähnen, dass die Aussparungen 3 in den Stirnflächen der Hülsenteile 1, 2 eine Passung mit dem Piezo-Stack bilden, deren Winkelspiel größer ist als das Winkelspiel der durch die Nut-Feder-Verbindung gebildeten Verdrehsicherung. Dadurch wird sichergestellt, dass die Hülsenteile 1, 2 im montierten Zustand keine Torsionskraft auf den Piezo-Stack ausüben.

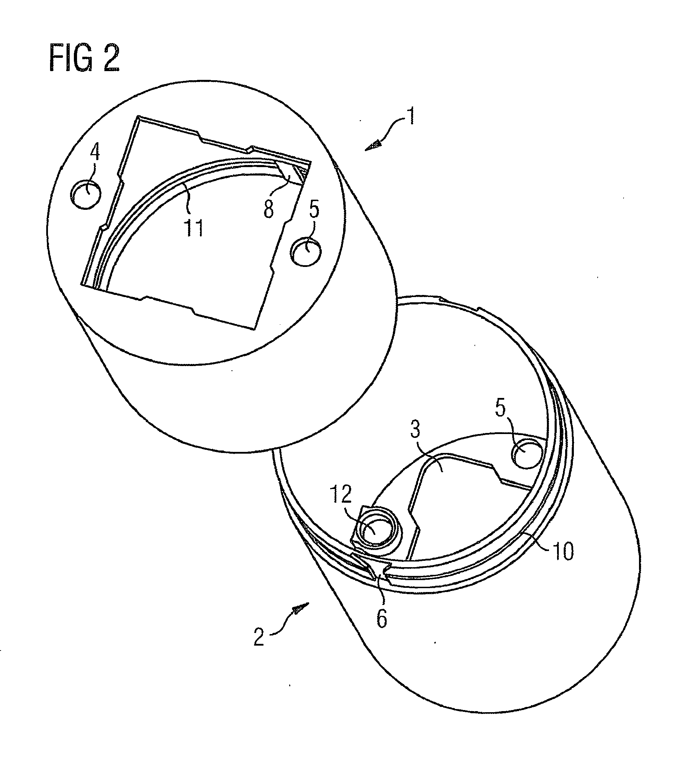

Schließlich zeigt Figur 2 noch, dass an der Innenseite des Hülsenteils 2 an die Stirnfläche und die Mantelfläche angrenzend auf gegenüberliegenden Seiten des Hülsenteils 2 zwei topfförmige Führungen 12 einstückig angeformt sind, die bei der Montage der erfindungsgemäßen Aufnahmehülse die Anschlussstifte für die elektrische Kontaktierung des Piezoaktors führen und dadurch eine Fehlausrichtung der Anschlussstifte während der Montage verhindern.

Die Anschlussstifte werden hierzu bei der Montage in die topfförmigen Führungen 12 eingesetzt und stoßen dann beim Aufstecken des anderen Hülsenteils 1 durch die Bohrungen 4, 5 hindurch.

Nach der Auffüllung der Aufnahmehülse mit einer Vergussmasse (z.B. Silikon) sind die beiden Anschlussstifte und der piezokeramische Stapel dann ohnehin fixiert, so dass deren korrekte Ausrichtung sicher gestellt bleibt.

## Patentansprüche

1. Aufnahmehülse für einen Piezoaktor mit zwei Anschlussstiften zur elektrischen Kontaktierung des Piezoaktors, insbesondere für einen Piezoaktor zum Antrieb eines Injektors einer Einspritzanlage für eine Brennkraftmaschine, mit
einem ersten Hülsenteil (1) und einem zweiten Hülsenteil (2),
wobei das erste Hülsenteil (1) im montierten Zustand mit dem zweiten Hülsenteil (2) verbunden ist,
während in dem ersten Hülsenteil (1) Durchführungen (4, 5) für die beiden Anschlussstifte des Piezoaktors angeordnet sind,
**dadurch gekennzeichnet,**
**dass** in dem zweiten Hülsenteil (2) mindestens eine Führung (12) für die beiden Anschlussstifte angeordnet ist und eine Verdrehsicherung (6, 8) zur Einhaltung einer vorgegebenen Winkellage zwischen dem ersten Hülsenteil (1) und dem zweiten Hülsenteil (2) vorgesehen ist.

2. Aufnahmehülse nach Anspruch 1,
**dadurch gekennzeichnet,**
**dass** die Führungen (12) für die beiden Anschlussstifte an dem zweiten Hülsenteil (2) einstückig angeformt sind.

3. Aufnahmehülse nach Anspruch 1 oder 2,
**dadurch gekennzeichnet,**
**dass** die Führungen (12) für die beiden Anschlussstifte an der Mantelfläche und an der Stirnfläche der zweiten Hülse (2) innen einstückig angeformt sind.

4. Aufnahmehülse nach einem der vorhergehenden Ansprüche,
**dadurch gekennzeichnet,**
**dass** die Führungen (12) für jeden der beiden Anschlussstifte jeweils topfförmig ausgebildet sind.

5. Aufnahmehülse nach einem der vorhergehenden Ansprüche,
**dadurch gekennzeichnet,**
**dass** die Führungen (12) für die Anschlussstifte des Piezoaktors jeweils als Querlager ausgebildet sind und eine Querbewegung der geführten Enden der Anschlussstifte verhindern.

6. Aufnahmehülse nach einem der vorhergehenden Ansprüche,
**dadurch gekennzeichnet,**
**dass** die Führungen (12) für die Anschlussstifte des Piezoaktors als Axiallager ausgebildet sind und eine Axialbewegung der Anschlussstifte zumindest in einer Axialrichtung verhindern.

7. Aufnahmehülse nach einem der vorhergehenden Ansprüche,
**dadurch gekennzeichnet,**
**dass** die Führungen (12) für die Anschlussstifte des Piezoaktors als Kippmomentenlager ausgebildet und eine Kippbewegung der Anschlussstifte verhindern.

8. Aufnahmehülse nach Anspruch 7,
**dadurch gekennzeichnet,**
**dass** die Verdrehsicherung (6, 8) eine Nut-Feder-Verbindung aufweist, die aus einer an einem der beiden Hülsenteile (1, 2) angebrachten Nut (6) und einer an dem anderen Hülsenteil (2) angebrachten, formangepassten Feder (8) besteht, die im montierten Zustand in die Nut (6) eingreift.

9. Aufnahmehülse nach Anspruch 8,
**dadurch gekennzeichnet,**
**dass** die Nut (6) und/oder die Feder (8) eine Einlaufschräge (7, 9) aufweist, wobei die Einlaufschräge (7, 9) eine Vormontage des ersten Hülsenteils (1) und des zweiten Hülsenteils (2) mit einem Winkelversatz ermöglicht.

10. Aufnahmehülse nach Anspruch 9,
**dadurch gekennzeichnet,**
**dass** der maximale Winkelversatz für die Vormontage im Bereich zwischen 1° und 10° liegt.

11. Aufnahmehülse nach Anspruch 9 oder 10,
**gekennzeichnet durch**
eine Steckverbindung zwischen dem ersten Hülsenteil (1) und dem zweiten Hülsenteil (2) mit einer vorgegebenen Steckverbindungslänge, wobei sich die Einlaufschräge (7, 9) in Axialrichtung nur über einen Teil der Steckverbindungslänge erstreckt.

12. Aufnahmehülse nach Anspruch 11,
**dadurch gekennzeichnet,**
**dass** sich die Einlaufschräge (7, 9) in Axialrichtung über 10% bis 50% der Steckverbindungslänge erstreckt.

13. Aufnahmehülse nach Anspruch 11 oder 12,
**dadurch gekennzeichnet,**
**dass** sich die Nut (6) und/oder die Feder (8) von dem jeweils freien Ende des jeweiligen Hülsenteils (1, 2) ausgehend mindestens über einen Teil der Steckverbindungslänge erstreckt, so dass die Feder (8) bereits während des Zusammensteckens der beiden Hülsenteile (1, 2) in die Nut (6) eingreift.

14. Aufnahmehülse nach einem der Ansprüche 11 bis 13,
**dadurch gekennzeichnet,**
**dass** sich die Nut (6) und/oder die Feder (8) der Nut-Feder-Verbindung über die gesamte Steckverbindungslänge erstreckt, wobei die Einlaufschräge (7, 9) einen Teil der Steckverbindungslänge einnimmt, während die Verdrehsicherung (6, 8) den gesamten Rest der Steckverbindungslänge einnimmt.

15. Aufnahmehülse nach einem der Ansprüche 9 bis 14,
**dadurch gekennzeichnet,**
**dass** sowohl die Nut (6) als auch die Feder (8) eine Einlaufschräge (7, 9) aufweist.

16. Aufnahmehülse nach Anspruch 15,
**dadurch gekennzeichnet,**
**dass** die Einlaufschräge (7) der Nut (6) im wesentlichen den gleichen Einlaufwinkel aufweist wie die Einlaufschräge (9) der Feder (8), so dass die beiden Einlaufschrägen (7, 9) bei der Montage im wesentlichen planparallel aufeinander gleiten.

17. Aufnahmehülse nach einem der vorhergehenden Ansprüche,
**dadurch gekennzeichnet,**
**dass** das erste Hülsenteil (1) im montierten Zustand mit dem zweiten Hülsenteil (2) durch eine Rastverbindung (10, 11) verbunden ist, die einen vorgegebenen Rastpunkt aufweist.

18. Aufnahmehülse nach Anspruch 17,
**dadurch gekennzeichnet,**
**dass** die Einlaufschräge (7, 9) beim Zusammenstecken der beiden Hülsenteile (1, 2) nur maximal bis zu dem Rastpunkt wirkt.

19. Aufnahmehülse nach einem der Ansprüche 9 bis 18,
**dadurch gekennzeichnet,**
**dass** die Einlaufschräge (7, 9) im wesentlichen gerade und ungekrümmt verläuft.

20. Aufnahmehülse nach einem der Ansprüche 9 bis 19,
**dadurch gekennzeichnet,**
**dass** die Einlaufschräge (7, 9) übergangslos in die Verdrehsicherung (6, 8) übergeht.

21. Aufnahmehülse nach einem der Ansprüche 9 bis 20,
**dadurch gekennzeichnet,**
**dass** die Einlaufschräge (7, 9) mit einem Knick in die Verdrehsicherung (6, 8) übergeht.

22. Aufnahmehülse nach einem der vorhergehenden Ansprüche,
**dadurch gekennzeichnet,**
**dass** das erste Hülsenteil (1) und das zweite Hülsenteil (2) jeweils in ihren Stirnflächen Aussparungen (3-5) zur Führung des Piezoaktors aufweisen.

23. Aufnahmehülse nach Anspruch 22,
**dadurch gekennzeichnet,**
**dass** der Piezoaktor mit den Aussparungen (3) eine Passung bildet, deren Winkelspiel größer ist, als das Winkelspiel der Verdrehsicherung, um Torsionskräfte auf den Piezoaktor zu verhindern.

## Claims

1. Reception bush for a piezoactuator with two connection pins for electrical contacting of the piezoactuator, especially for a piezoactuator for driving an injector of an injection system for an internal combustion engine, with
a first bush element (1) and a second bush element (2),
with the first bush element (1) being connected in the assembled state to the second bush element (2),
while through holes (4, 5) are arranged in the first bush element (1) for the two connection pins of the piezoactuator,
**characterised in that**,
at least one guide (12) for the two connection pins is arranged in the second bush element (2) and an anti-rotation device (6, 8) for retaining a predetermined angular position is provided between the first bush element (1) and the second bush element (2).

2. Reception bush in accordance with claim 1,
**characterised in that**
the guides (12) for the two connection pins are formed in one piece on the second bush element (2).

3. Reception bush in accordance with claim 1 or 2,
**characterised in that**
the guides (12) for the two connection pins are formed in one piece inside on the lateral surface and the face surface of the second bush (2).

4. Reception bush in accordance with one of the previous claims,
**characterised in that**
the guides (12) for each of the two connection pins are embodied in a barrel shape in each case.

5. Reception bush in accordance with one of the previous claims,
**characterised in that**
the guides (12) for the connection pins of the piezoactuator are embodied as transverse supports in each case and prevent a transverse movement of the guided ends of the connection pins.

6. Reception bush in accordance with one of the previous claims,
**characterised in that**
the guides (12) for the connection pins of the piezoactuator are embodied as an axial support and prevent an axial movement of the connection pins at least in an axial direction.

7. Reception bush in accordance with one of the previous claims,
**characterised in that**
the guides (12) for the connection pins of the piezoactuator are embodied as tipping moment supports and prevent a tipping movement of the connection pins.

8. Reception bush in accordance with one of the previous claims,
**characterised in that**
the anti-rotation device (6, 8) features a groove-spring connection, consisting of a groove (6) made in one of the two bush elements (1, 2) and a matching spring (8) formed in the other bush element (2), which engages with the groove (6) in the assembled state.

9. Reception bush in accordance with claim 8
**characterised in that**
the groove (6) and/or the spring (8) features an insertion taper (7, 9), with the insertion taper (7, 9) allowing pre-assembly of the first bush element (1) and of the second bush element (2) with an angular offset.

10. Reception bush in accordance with claim 9,
**characterised in that**
the maximum angular offset for pre-assembly lies in the range of between 1° and 10° lies.

11. Reception bush in accordance with claim 9 or 10,
**characterised in that**
a plug-in connection between the first bush element (1) and the second bush element (2) with a predetermined plug-in connection length, with the insertion taper (7, 9) only extending in the axial direction over a part of the plug-in connection length.

12. Reception bush in accordance with claim 11, **characterised in that** the insertion taper (7, 9) extends in the axial direction over 10% to 50% of the plug-in connection length.

13. Reception bush in accordance with claim 11 or 12,
**characterised in that**
the groove (6) and/or the spring (8) extends, starting from the free end of the relevant bush element (1, 2) in each case at least over a part of the plug-in connection length, so that the spring (8) engages even during of the putting together of the two bush elements (1, 2) into the groove (6).

14. Reception bush in accordance with one of the claims 11 to 13,
**characterised in that**
the groove (6) and/or the spring (8) of the groove-spring connection extends over the entire length of the plug-in connection, with the insertion taper (7, 9) taking up a part of the plug-in connection length, whereas the anti-rotation device (6, 8) takes up the entire remainder of the plug-in connection length.

15. Reception bush in accordance with one of the claims 10 to 15,
**characterised in that**
the groove (6) and also the spring (8) features an insertion taper (7, 9).

16. Reception bush in accordance with claim 15,
**characterised in that**
the insertion taper (7) of the groove (6) has essentially the same insertion angle as the insertion angle (9) of the spring (8), so that the two insertion angles (7, 9) essentially slide planparallel on each other during assembly.

17. Reception bush in accordance with one of the previous claims,
**characterised in that**
the first bush element (1) in the assembled state is connected to the second bush element (2) by a snap-on connection (10, 11) which features a predetermined snap-on point.

18. Reception bush in accordance with claim 17,
**characterised in that**
the insertion taper (7, 9) only operates up to a maximum of the first snap-on point when the two bush elements (1, 2) are put together.

19. Reception bush in accordance with one of the claims 9 to 18,
**characterised in that**
the tapers (7, 9) run essentially straight and without bumps.

20. Reception bush in accordance with one of the claims 9 to 19,
**characterised in that**
the tapers (7, 9) pass into the anti-rotation device (6, 8) without any transition.

21. Reception bush in accordance with one of the claims 9 to 20,
**characterised in that**
there is a kink at the transition point between the insertion tapers (7, 9) and the anti-rotation device (6, 8).

22. Reception bush in accordance with one of the previous claims, **characterized in that**,
the first bush element (1) and the second bush element (2) each feature cutouts (3-5) in their end faces for guiding the piezoactuator.

23. Reception bush in accordance with claim 22,
**characterised in that**
the piezoactuator with the cutouts (3) forms a fit of which the angular play is greater than the angular play of the anti-rotation device, to prevent rotation forces on the piezoactuator.

## Revendications

1. Étui enveloppe pour un piézo-actionneur, comprenant deux broches de connexion pour le branchement électrique du piézo-actionneur, en particulier pour un piézo-actionneur servant à la commande d'un injecteur d'une installation d'injection pour moteur à combustion interne, comprenant
une première partie (1) d'étui et une deuxième partie (2) d'étui,
la première partie (1) d'étui étant assemblée à la deuxième partie (2) d'étui à l'état monté,
cependant que, dans la première partie (1) d'étui, sont disposés des passages (4, 5) pour les deux broches de connexion du piézo-actionneur, **caractérisé**
**en ce qu'**au moins un guidage (12) pour les deux broches de connexion est disposé dans la deuxième partie (2) d'étui et qu'il est prévu un blocage anti-torsion (6, 8) servant à maintenir une position angulaire prédéterminée entre la première partie (1) d'étui et la deuxième partie (2) d'étui.

2. Étui enveloppe selon la revendication 1,
**caractérisé**
**en ce que** les guidages (12) pour les deux broches de connexion sont venus de matière en une seule pièce sur la deuxième partie (2) d'étui.

3. Étui enveloppe selon la revendication 2,
**caractérisé**
**en ce que** les guidages (12) pour les deux broches de connexion sont venus de matière intérieurement en une seule pièce sur la surface latérale et la surface frontale du deuxième étui (2).

4. Étui enveloppe selon une des revendications précédentes,
**caractérisé**
**en ce que** les guidages (12) sont conformés en forme de godet chacun pour chacune des deux broches de connexion.

5. Étui enveloppe selon une des revendications précédentes,
**caractérisé**
**en ce que** les guidages (12) pour les broches de connexion du piézo-actionneur sont conformés chacun en forme d'appui transversal et s'opposent à un déplacement transversal des extrémités guidées des broches de connexion.

6. Étui enveloppe selon une des revendications précédentes,
**caractérisé**
**en ce que** les guidages (12) pour les broches de connexion du piézo-actionneur sont constitués par des appuis axiaux et s'opposent à un déplacement axial des broches de connexion au moins dans une direction axiale.

7. Étui enveloppe selon une des revendications précédentes,
**caractérisé**
**en ce que** les guidages (12) pour les broches de connexion du piézo-actionneur sont constitués par des appuis anti-couple de basculement et s'opposent à un mouvement de basculement des broches de connexion.

8. Étui enveloppe selon la revendication 7,
**caractérisé**
**en ce que** le blocage anti-torsion (6, 8) présente un assemblage à rainure et languette qui est composé d'une rainure (6) prévue sur une des deux parties (1, 2) de l'étui et une languette (8) de forme adaptée, prévue sur l'autre partie (2) de l'étui et qui est engagée dans la rainure (6) à l'état monté.

9. Étui enveloppe selon la revendication 8,
**caractérisé**
**en ce que** la rainure (6) et/ou la languette (8) présentent un chanfrein d'entrée (7, 9), le chanfrein (7, 9) permettant d'effectuer un pré-montage de la première partie (1) de l'étui et de la deuxième partie (2) de l'étui avec un décalage angulaire.

10. Étui enveloppe selon la revendication 9,
**caractérisé**
**en ce que** le décalage angulaire maximal pour le pré-montage se trouve dans l'intervalle entre 1 ° et 10 °.

11. Étui enveloppe selon la revendication 9 ou 10,
**caractérisé**
**par** un assemblage à emboîtement entre la première partie (1) de l'étui et la deuxième partie (2) de l'étui, possédant une longueur d'assemblage à emboîtement prédéterminée, le chanfrein (7, 9) s'étendant seulement sur une partie de la longueur de l'assemblage à emboîtement dans la direction axiale.

12. Étui enveloppe selon la revendication 11,
**caractérisé**
**en ce que** le chanfrein d'entrée (7, 9) s'étend dans la direction axiale sur 10 % à 50 % de la longueur de l'assemblage à emboîtement.

13. Étui enveloppe selon la revendication 11 ou 12,
**caractérisé**
**en ce que** la rainure (6) et/ou la languette (8) s'étendent au moins sur une partie de la longueur de l'assemblage à emboîtement (6), chacune en partant de l'extrémité libre correspondante de la partie respective (1, 2) de l'étui, de sorte que la languette (8) s'engage déjà dans la rainure (6) au cours de l'emboîtement mutuel des deux parties (1, 2) de l'étui.

14. Étui enveloppe selon une des revendications 11 à 13,
**caractérisé**
**en ce que** la rainure (6) et/ou la languette (8) de l'assemblage à rainure et languette s'étendent sur toute la longueur de l'assemblage à emboîtement, le chanfrein d'entrée (7, 9) occupant une partie de la longueur de l'assemblage à emboîtement, tandis que le blocage anti-torsion (6, 8) occupe tout le reste de la longueur de l'assemblage à emboîtement.

15. Étui enveloppe selon une des revendications 9 à 14,
**caractérisé**
**en ce qu'**aussi bien la rainure (6) que la languette (8) présente un chanfrein d'entrée (7, 9).

16. Étui enveloppe selon la revendication 15,
**caractérisé**
**en ce que** le chanfrein d'entrée (7) de la rainure (6) présente sensiblement le même angle d'entrée que le chanfrein d'entrée (9) de la languette (8), de sorte que les deux chanfreins d'entrée (7, 9) glissent l'un sur l'autre dans des plans sensiblement parallèles lors du montage.

17. Étui enveloppe selon une des revendications précédentes,
**caractérisé**
**en ce qu'**à l'état monté, la première partie (1) de l'étui est assemblée à la deuxième partie (2) de l'étui par un assemblage à encliquetage (10, 11) qui présente un point d'encliquetage prédéterminé.

18. Étui enveloppe selon la revendication 17,
**caractérisé**
**en ce que** lors de l'emboîtement des deux parties (1, 2) de l'étui, le chanfrein d'entrée (7, 9) n'agit au maximum que jusqu'au point d'encliquetage.

19. Étui enveloppe selon une des revendications 9 à 18,
**caractérisé**
**en ce que** le chanfrein d'entrée (7, 9) s'étend sensiblement en ligne droite et est dépourvu de courbure.

20. Étui enveloppe selon une des revendications 9 à 19,
**caractérisé**
**en ce que** le chanfrein d'entrée (7, 9) se termine sans transition dans le verrouillage anti-torsion (6, 8).

21. Étui enveloppe selon une des revendications 9 à 20,
**caractérisé**
**en ce que** le chanfrein d'entrée (7, 9) se termine dans le verrouillage anti-torsion (6, 8) avec un angle vif.

22. Étui enveloppe selon une des revendications précédentes,
**caractérisé**
**en ce que** la première partie (1) de l'étui et la deuxième partie (2) de l'étui présentent respectivement dans leurs surfaces frontales des évidements (3-5) pour le guidage du piézo-actionneur.

23. Étui enveloppe selon la revendication 22,
**caractérisé**
**en ce que** le piézo-actionneur forme avec les évidements (3) un ajustement dont le jeu angulaire est plus grand que le jeu angulaire du blocage anti-torsion, afin d'éviter l'application de forces de torsion sur le piézo-actionneur.
